(19) Europäisches Patentamt
European Patent Office
Office européen des brevets

(11) Veröffentlichungsnummer: **0 026 820**
**B1**

(12) # EUROPÄISCHE PATENTSCHRIFT

(45) Veröffentlichungstag der Patentschrift: **11.05.83**

(51) Int. Cl.[3]: **G 03 C 1/70**, G 03 F 7/10, C 08 L 75/00, C 08 L 79/00

(21) Anmeldenummer: **80104639.2**

(22) Anmeldetag: **06.08.80**

(54) **Verfahren zur Herstellung hochwärmebeständiger Reliefstrukturen, danach hergestellte Reliefstrukturen und deren Verwendung.**

(30) Priorität: **21.08.79 DE 2933827**

(43) Veröffentlichungstag der Anmeldung: **15.04.81 Patentblatt 81/15**

(45) Bekanntmachung des Hinweises auf die Patenterteilung: **11.05.83 Patentblatt 83/19**

(84) Benannte Vertragsstaaten: **AT BE CH DE FR GB IT LI NL SE**

(56) Entgegenhaltungen:
**DE A 2 308 830**
**DE A 2 405 714**
**DE A 2 434 912**
**DE A 2 830 143**
**FR A 2 316 627**
**US A 4 108 666**

(73) Patentinhaber: **SIEMENS AKTIENGESELLSCHAFT**
**Berlin und München Wittelsbacherplatz 2**
**D-8000 München 2 (DE)**

(72) Erfinder: **Ahne, Hellmut, Dr.**
**Heidestrasse 6**
**D-8551 Röttenbach (DE)**
Erfinder: **Rubner, Roland, Dr.**
**Buchenring 15**
**D-8551 Röttenbach (DE)**
Erfinder: **Kühn, Eberhard**
**Bergstrasse 32**
**D-8551 Hemhofen (DE)**
Erfinder: **Schmidt, Erwin**
**Elise-Späth-Strasse 23**
**D-8520 Erlangen (DE)**

EP 0 026 820 B1

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Jouve, 18, rue St-Denis, 75001 Paris, France

# Verfahren zur Herstellung hochwärmebeständiger Reliefstrukturen, danach hergestellte Reliefstrukturen und deren Verwendung

Die Erfindung betrifft ein Verfahren zur Herstellung hochwärmebeständiger Reliefstrukturen auf der Basis von Polyimiden, Polyisoindolochinazolindionen, Polyoxazindionen und Polychinazolindionen durch Auftragen strahlungsempfindlicher löslicher Polymer-Vorstufen in Form einer Schicht oder Folie auf ein Substrat, Bestrahlen der Schicht bzw. Folie durch Negativvorlagen mit aktinischem Licht oder durch Führen eines Licht-, Elektronenoder Ionenstrahls, Entfernen der nichtbestrahlten Schicht- bzw. Folienteile und gegebenenfalls durch nachfolgendes Tempern, sowie die Verwendung derart hergestellter Reliefstrukturen.

Aus der deutschen Patentschrift 2 308 830 bzw. der entsprechenden US-Patentschrift 3 957 512 ist ein Verfahren zur Herstellung von Reliefstrukturen der genannten Art bekannt. Bei diesem Verfahren werden als lösliche Polymer-Vorstufen Polyadditions- oder Polykondensationsprodukte polyfunktioneller carbocyclischer oder heterocyclischer, strahlungsempfindliche Reste tragender Verbindungen mit Diaminen, Diisocyanaten, Bis-säurechloriden oder Dicarbonsäuren verwendet. Die Verbindungen, die strahlungsempfindliche Reste tragen, enthalten dabei zwei für Additions- oder Kondensationsreaktionen geeignete Carboxyl-, Carbonsäurechlorid-, Amino-, Isocyanat- oder Hydroxylgruppen und teilweise in ortho- oder peri-Stellung dazu esterartig an Carboxylgruppen gebundene strahlungsreaktive Gruppen. Die mit diesen Verbindungen umzusetzenden Diamine, Diisocyanate, Bis-säurechloride und Dicarbonsäuren weisen mindestens ein cyclisches Strukturelement auf.

Die löslichen Polymer-Vorstufen werden beim Bestrahlen vernetzt und gehen dabei in unlösliche Zwischenprodukte über. Diese Zwischenprodukte unterliegen bei der Temperung einer Cyclisierung, wobei hochwärmebeständige Polymere folgender Stoffklassen gebildet werden : Polyimide, Polyamidimide, Polyesterimide, Poly-1,3-chinazolin-2,6-dione, Polyisoindolochinazolindione, Poly-1,3-oxazin-6-one und Polybenz-1,3-oxazin-2,4-dione.

Die nach dem bekannten Verfahren hergestellten Reliefstrukturen haben sich in der Praxis gut bewährt. Es hat sich aber auch gezeigt, daß noch Schwierigkeiten auftreten, die auf die Polymer-Vorstufen zurückzuführen sind. Diese weisen nämlich, bedingt durch das Herstellungsverfahren, bei dem Säurechloride eingesetzt werden, einen Restchlorgehalt auf, der nur unter großem Aufwand und begrenzt beseitigt werden kann. Darüber hinaus ist auch der Einsatz von Polymer-Vorstufen mit verbesserter Löslichkeit wünschenswert.

Aufgabe der Erfindung ist es, das Verfahren der eingangs genannten Art zur Herstellung hochwärmebeständiger Reliefstrukturen weiter zu verbessern, wobei insbesondere eine erhöhte Reinheit der Reliefstrukturen erzielt werden soll ; darüber hinaus soll aber auch deren Herstellung vereinfacht werden.

Dies wird erfindungsgemäß dadurch erreicht, daß als Polymer-Vorstufen Additionsprodukte von olefinisch ungesättigten Monoepoxiden an carboxylgruppenhaltige Polyadditionsprodukte aus aromatischen und/oder heterocyclischen Tetracarbonsäuredianhydriden und Diaminoverbindungen, welch letztere wenigstens eine ortho-ständige Amidogruppe enthalten können, bzw. an carboxylgruppenhaltige Polyadditionsprodukte aus aromatischen und/oder heterocyclischen Dihydroxydicarbonsäuren oder entsprechenden Diaminodicarbonsäuren und Diisocyanaten verwendet werden.

Nach dem erfindungsgemäßen Verfahren können Reliefstrukturen in vereinfachter Weise hergestellt werden, weil die dabei verwendeten Polymer-Vorstufen — aufgrund des Vorhandenseins von Hydroxylgruppen — zumindest zum Teil in bzw. aus partiell wäßriger Lösung verarbeitet werden können. Darüber hinaus weisen die nach dem erfindungsgemäßen Verfahren hergestellten Reliefstrukturen eine erhöhte Reinheit auf, wobei insbesondere das Fehlen von Chlorverunreinigungen wesentlich ist.

Beim erfindungsgemäßen Verfahren können die Polymer-Vorstufen vorteilhaft zusammen mit licht- oder strahlungsempfindlichen copolymerisationsfähigen Verbindungen eingesetzt werden. Dazu werden vorzugsweise N-substituierte Maleinimide verwendet. Es können aber auch acrylat- bzw. methacrylatgruppenhaltige Verbindungen eingesetzt werden. Weiter können auch übliche Photoinitiatoren und/oder -sensibilisatoren verwendet werden (vgl. : « Industrie Chimique Belge », *24*, 1959, S. 739 bis 764, sowie J. Kosar, « Light-Sensitive Systems », John Wiley & Sons Inc., New York 1965, S. 143 bis 146 und S. 160 bis 188). Besonders geeignet sind Michlers Keton und/oder Benzoinäther, 2-tert.Butyl-9,10-anthrachinon, 1,2-Benz-9,10-anthrachinon und 4,4'-Bis(diäthylamino)-benzophenon. Ferner können beim erfindungsgemäßen Verfahren vorteilhaft Haftvermittler verwendet werden. Dazu dienen insbesondere Silane, wie Vinyltriäthoxysilan, Vinyl-tris (β-methoxy-äthoxy)-silan, γ-Methacryloxy-propyl-trimethoxysilan und γ-Glycidoxy-propyl-trimethoxysilan.

Die beim erfindungsgemäßen Verfahren eingesetzten strahlungsreaktiven Vorstufen, die oligomer und/oder polymerer Natur sind, sind in der gleichzeitig eingereichten europäischen Patentanmeldung « Polyimid-, Polyisoindolochinazolindion-, Polyoxazindion- und Polychinazolindion-Vorstufen sowie deren Herstellung », EP-A1-27 506, beschrieben. Diese Vorstufen weisen im allgemeinen folgende Struktur auf :

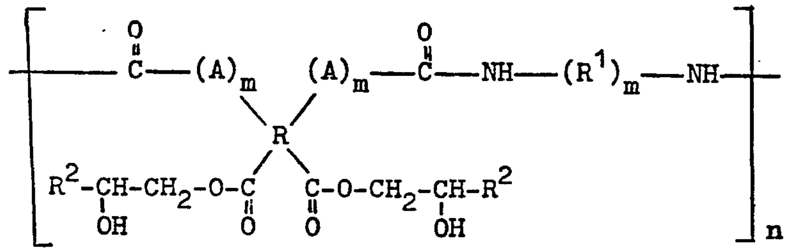

(1)

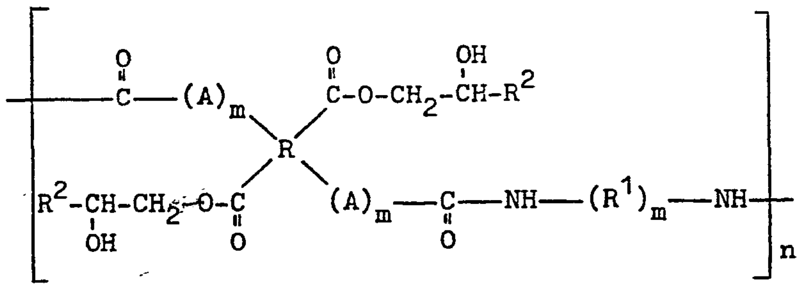

(2)

In den Formeln (1) und (2) bedeutet n eine ganze Zahl von 2 bis etwa 100 und m ist 0 oder 1.

Für R, $R^1$, $R^2$ und A gilt folgendes :

R ist ein — gegebenenfalls halogenierter — zumindest partiell aromatischer und/oder heterocyclischer tetravalenter, d. h. tetrafunktioneller Rest, bei dem jeweils zwei Valenzen in Nachbarstellung zueinander angeordnet sind ; weist der Rest R mehrere aromatische und/oder heterocyclische Strukturelemente auf, so befinden sich die Valenzpaare jeweils an endständigen derartigen Strukturelementen ;

$R^1$ ist ein — gegebenenfalls halogenierter — divalenter, d. h. difunktioneller Rest aliphatischer und/oder cycloaliphatischer, gegebenenfalls Heteroatome aufweisender, und/oder aromatischer und/oder heterocyclischer Struktur ;

$R^2$ ist ein olefinisch ungesättigter Rest, beispielsweise eine allylätherhaltige Gruppe, insbesondere eine — gegebenenfalls substituierte — (meth)acrylesterhaltige Gruppe ;

A bedeutet —O— oder —NH—.

Bevorzugt sin dabei Additionsprodukte von Glycidylacrylat oder -methacrylat an das Polyadditionsprodukt aus Pyromellithsäure- oder Benzophenontetracarbonsäuredianhydrid und Diaminodiphenyläther und Additionsprodukte von Glycidylacrylat oder -methacrylat an das Polyadditionsprodukt aus Dihydroxydiphenylmethandicarbonsäure und Diphenylmethandiisocyanat. Beispiele für derartige Polymer-Vorstufen sind in den nachfolgenden Formeln (3) und (4) dargestellt :

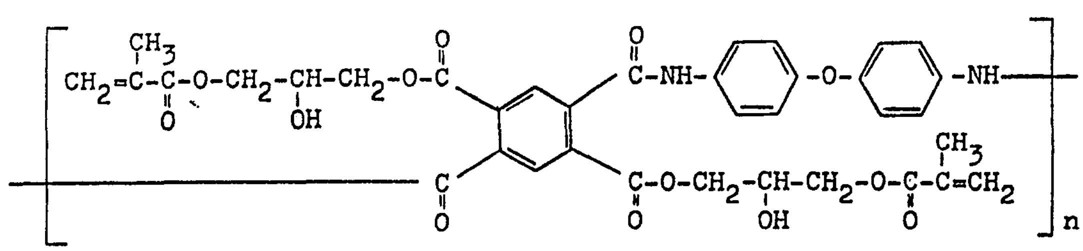

(3)

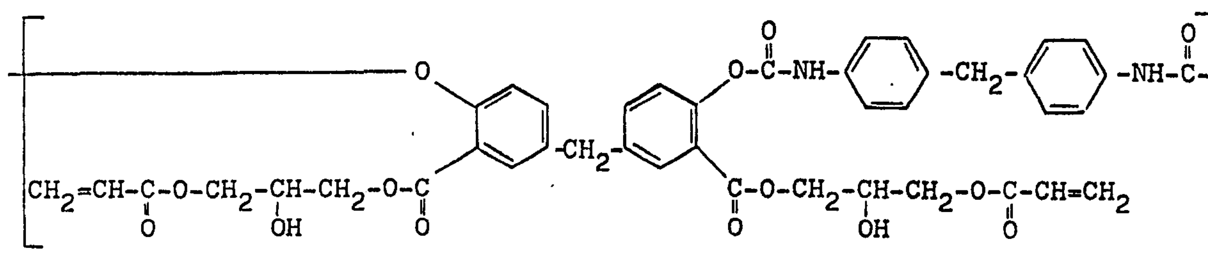

(4)

Formel (3) zeigt dabei eine Polyimid-Vorstufe und

Formel (4) eine Polyoxazindion-Vorstufe.

Die Herstellung der erfindungsgemäßen Reliefstrukturen erfolgt, wie bereits ausgeführt, in der Weise,

daß die Polymer-Vorstufe in Form einer Schicht oder Folie auf ein Substrat aufgebracht und mit aktinischem Licht durch eine Maske belichtet oder durch Führen eines Licht-, Elektronen- oder Ionenstrahls bestrahlt wird ; anschließend werden die nichtbelichteten bzw. nichtbestrahlten Schicht- oder Folienteile herausgelöst oder abgezogen und die dabei erhaltenen Reliefstrukturen werden gegebenenfalls getempert. Die Vorstufe kann vorteilhaft in einem organischen Lösungsmittel gelöst auf das Substrat aufgebracht werden ; vorzugsweise wird als Lösungsmittel N-Methylpyrrolidon verwendet. Die Konzentration der Lösung kann so eingestellt werden, daß mit bekannten Beschichtungsverfahren, wie Schleudern, Tauchen, Sprühen, Bürsten oder Rollen, Schichtstärken von 0,01 µm bis einige 100 µm erzeugt werden können. Es hat sich gezeigt, daß beispielsweise beim Schleuderbeschichten 300 bis 10 000 Umdrehungen/min für die Dauer von 1 bis 100 Sekunden geeignet sind, um eine gleichmäßige und gute Oberflächenqualität zu erzielen. Die auf das Substrat, das vorzugsweise aus Glas, Metall, Kunststoff oder halbleitendem Material besteht, aufgebrachte Photoresistschicht kann bei Raumtemperatur oder bei erhöhter Temperatur, vorzugsweise bei einer Temperatur von 50 bis 80 °C, in einem Stickstoff- oder Luftstrom vom Lösungsmittel befreit werden ; dabei kann auch im Vakuum gearbeitet werden.

Zur Erzielung eines ausreichenden Löslichkeitsunterschiedes zwischen den bestrahlten und den nichtbestrahlten Schicht- bzw. Folienteilen genügen beim erfindungsgemäßen Verfahren — bei der Verwendung einer 500 W-Quecksilberhöchstdrucklampe — in Abhängigkeit von der Zusammensetzung und der Schichtstärke Belichtungszeiten zwischen 20 und 800 Sekunden. Nach dem Belichten werden die nichtbelichteten Teile der Schicht bzw. Folie herausgelöst, vorzugsweise mit einem organischen Entwickler.

Mittels des erfindungsgemäßen Verfahrens werden konturenscharfe Bilder, d. h. Reliefstrukturen, erhalten, die durch Temperung in hochwärmebeständige, gegenüber Säuren und Laugen resistente Polymere umgewandelt werden. Im allgemeinen können Temperaturen von 220 bis 500 °C gewählt werden, vorzugsweise wird bei Temperaturen von 300 bis 400 °C getempert. Die Temperzeit beträgt im allgemeinen eine halbe Stunde, wobei unter Inertgas keine Verfärbung zu beobachten ist. Die Kantenschärfe und die Maßgenauigkeit der Reliefstrukturen werden durch die Temperung praktisch nicht beeinträchtigt. Darüber hinaus bleibt die gute Oberflächenqualität der Reliefstrukturen trotz eines beim Tempern eintretenden Schichtstärkenverlustes erhalten.

Beim erfindungsgemäßen Verfahren werden vorzugsweise Polymer-Vorstufen aus aromatischen Komponenten eingesetzt, so daß bei der thermischen Behandlung, d. h. bei der Temperung, Polymere mit folgenden Struktureinheiten gebildet werden :

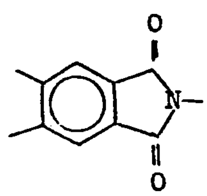 (5) ; 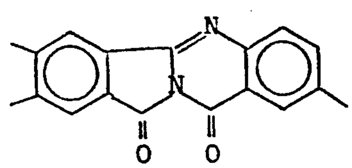 (6)

Polyimid Polyisoindolochinazolindion

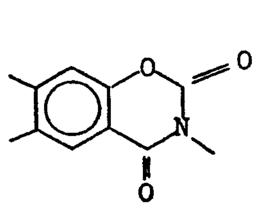 (7) ; 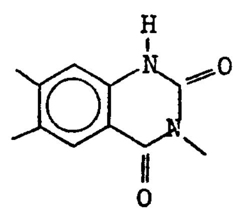 (8).

Polyoxazindion Polychinazolindion

Der Begriff « Polyimide » soll dabei auch Polyesterimide (9) und Polyamidimide (10) umfassen :

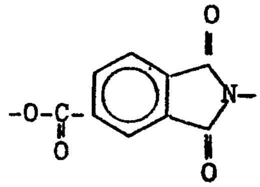 (9) ; 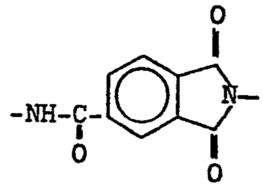 (10)

Die genannten Verbindungsklassen zählen zu den Halb-Leiterpolymeren bzw. Leiterpolymeren und zeichnen sich durch eine hohe Temperaturbeständigkeit aus (bis zu ca. 500 °C).

Die erfindungsgemäßen Reliefstrukturen können zur Herstellung von Passivierungsschichten auf Halbleiterbauelementen, von Dünn- und Dickfilmschaltungen, von Lötschutzschichten auf Mehrlagenschaltungen, von Isolierschichten als Bestandteil von Schichtschaltungen und von miniaturisierten Isolierschichten auf elektrisch leitenden und/oder halbleitenden und/oder isolierenden Basismaterialien, insbesondere im Bereich der Mikroelektronik oder allgemein für die Feinstrukturierung von Substraten, Anwendung finden. Vorzugsweise dienen die hochwärmebeständigen Reliefstrukturen als Masken für Naß- und Trockenätzprozesse, stromlose oder galvanische Metallabscheidung und Aufdampfverfahren sowie als Masken für die Ionenimplantation, darüber hinaus als Isolier- und Schutzschichten in der Elektrotechnik. Ferner können die Reliefstrukturen vorteilhaft als Orientierungsschichten, beispielsweise in Flüssigkristalldisplays, sowie zur Rasterung von Oberflächen, beispielsweise bei Röntgenschirmen, insbesondere Röntgenbildverstärkern, verwendet werden.

Anhand von Ausführungsbeispielen soll die Erfindung noch näher erläutert werden.

## Beispiel 1

### Herstellung einer strahlungsreaktiven Polyimid-Vorstufe

Zu 65,4 Gewichtsteilen Pyromellithsäuredianhydrid (0,3 Mol) in 450 Volumenteilen Dimethylacetamid werden unter Rühren 45 Gewichtsteile 4,4'-Diaminodiphenyläther (0,23 Mol) gegeben und anschließend wird 2 Stunden lang bei Raumtemperatur gerührt. Dann werden dem Reaktionsgemisch 2 Gewichtsteile Methacrylsäure-2-hydroxyäthylester (0,016 Mol) zugesetzt, um die noch vorhandenen endständigen Anhydridgruppen zu binden. Nach 2 stündigem Rühren bei Raumtemperatur werden zur Reaktionslösung 150 Volumenteile Glycidylmethacrylat, 1,5 Gewichtsteile Benzyldimethylamin und 0,1 Gewichtsteile Hydrochinon gegeben. Anschließend wird die Lösung unter Rühren 23 Stunden auf eine Temperatur von 50 bis 60 °C erwärmt und dann wird sie unter kräftigem Rühren zu 4 000 Volumenteilen Äthanol getropft. Der dabei gebildete Niederschlag wird abgesaugt und im Vakuum bei Raumtemperatur getrocknet.

### Herstellung der Reliefstruktur

20 Gewichtsteile der auf die vorstehend beschriebene Weise hergestellten Polyimid-Vorstufe werden zusammen mit 1 Gewichtsteil N-Phenylmaleinimid und 0,4 Gewichtsteilen Michlers Keton sowie 0,2 Gewichtsteilen Vinyltriäthoxysilan in 80 Volumenteilen Dimethylacetamid gelöst. Die Lösung wird durch ein Filter filtriert und bei 2 500 Umdrehungen pro Minute zu gleichmäßigen Filmen auf eine Aluminiumfolie und einen Siliciumwafer mit Siliciumnitridoberfläche geschleudert. Nach dem Trocknen beträgt die Schichtstärke 2,5 μm. Die Filme werden dann mit einer 500 W-Quecksilberhöchstdrucklampe durch eine Kontaktmaske 40 Sekunden lang belichtet und anschließend 20 Sekunden in Dimethylacetamid bzw. in einem Gemisch aus Dimethylacetamid und γ-Butyrolacton (Volumenverhältnis 1 : 1) 40 Sekunden lang entwickelt. Dabei werden kantenscharfe Reliefstrukturen erhalten, die erzielte Auflösung liegt unterhalb 4 μm. Die Reliefstrukturen erfahren auch durch eine anschließende Temperung bei 400 °C (Dauer : 30 Minuten) keine Beeinträchtigung.

Die auf die beschriebene Weise hergestellten Reliefstrukturen weisen die ausgezeichneten thermischen, elektrischen, chemischen und mechanischen Eigenschaften des Polyimids Polydiphenylätherpyromellithimid auf. Das IR-Spektrum der getemperten Proben zeigt die für die Imidstruktur typische Bande bei 5,6 μm.

## Beispiel 2

### Herstellung einer strahlungsreaktiven Polybenzoxazindion-Vorstufe

Zu einer Lösung von 28,8 Gewichtsteilen Methylendisalicylsäure (0,1 Mol) und 0,1 Gewichtsteilen 1,4-Diazabicyclo [2.2.2] octan als Katalysator in 100 Volumenteilen N-Methylpyrrolidon werden bei Raumtemperatur unter Rühren 25 Gewichtsteile p,p'-Diphenylmethandiisocyanat (0,1 Mol), gelöst in 50 Volumenteilen N-Methylpyrrolidon, langsam zugetropft. Nach einer Reaktionszeit von 20 Stunden bei Raumtemperatur werden zu dieser Lösung unter Rühren 75 Volumenteile Glycidylacrylat und 0,1 Gewichtsteile Hydrochinon gegeben. Nach einer weiteren Reaktionszeit von 20 Stunden bei einer Temperatur von 50 bis 60 °C und 48 Stunden bei Raumtemperatur wird das Harz mit 2 000 Volumenteilen Toluol ausgefällt und im Vakuum getrocknet.

### Herstellung der Reliefstruktur

10 Gewichtsteile der auf die vorstehend beschriebene Weise hergestellten Polybenzoxazindion-Vorstufe, 0,5 Gewichtsteile N-Phenylmaleinimid, 0,2 Gewichtsteile Michlers Keton und 0,1 Gewichtsteile Vinyltriäthoxysilan werden in 30 Volumenteilen einer Mischung von Dimethylacetamid und Dioxan

(Volumenverhältnis 1 : 1) gelöst. Die Lösung wird filtriert und bei 2 500 Umdrehungen pro Minute auf einer Aluminiumfolie sowie einem Siliciumwafer zu homogenen Filmen geschleudert. Nach 2 stündigem Trocknen bei 70 °C im Vakuum werden die Filme mit einer 500 W-Quecksilberhöchstdrucklampe durch eine Gitterstrukturtestmaske im Kontaktverfahren 30 Sekunden lang belichtet, dann wird 5 bis 10 Sekunden mit einem Gemisch aus γ-Butyrolacton und Toluol (Volumenverhältnis 1 : 1) entwickelt und mit Toluol gewaschen.

Auf diese Weise wird ein Auflösungsvermögen von 3 μm bei guter Kantenschärfe der Reliefstrukturen erreicht. Die Reliefstrukturen können ohne Beeinträchtigung des Auflösungsvermögens und der Kantenschärfe 1/2 Stunde bei 275 °C und eine halbe Stunde bei 400 °C getempert werden. Die Schichtstärke nach der Temperung beträgt 1,1 μm bei einer Ausgangsschichtstärke von 2,5 μm.

## Ansprüche

1. Verfahren zur Herstellung hochwärmebeständiger Reliefstrukturen auf der Basis von Polyimiden, Polyisoindolochinazolindionen, Polyoxazindionen und Polychinazolindionen durch Auftragen strahlungsempfindlicher löslicher Polymer-Vorstufen in Form einer Schicht oder Folie auf ein Substrat, Bestrahlen der Schicht bzw. Folie durch Negativvorlagen mit aktinischem Licht oder durch Führen eines Licht-, Elektronen- oder Ionenstrahls, Entfernen der nichtbestrahlten Schicht- bzw. Folienteile und gegebenenfalls durch nachfolgendes Tempern, dadurch gekennzeichnet, daß als Polymer-Vorstufen Additionsprodukte von olefinish ungesättigten Monoepoxiden an carboxylgruppenhaltige Polyadditionsprodukte aus aromatischen und/oder heterocyclischen Tetracarbonsäuredianhydriden und Diaminoverbindungen, welchletztere wenigstens eine ortho-ständige Amidogruppe enthalten können, bzw. an carboxylgruppenhaltige Polyadditionsprodukte aus aromatischen und/oder heterocyclischen Dihydroxydicarbonsäuren oder entsprechenden Diaminodicarbonsäuren und Diisocyanaten verwendet werden.

2. Verfahren nach Anspruch 1, dadurch gekennzeichnet, daß die Polymer-Vorstufen zusammen mit licht- oder strahlungsempfindlichen copolymerisationsfähigen Verbindungen eingesetzt werden.

3. Verfahren nach Anspruch 2, dadurch gekennzeichnet, daß als copolymerisationsfähige Verbindungen N-substituierte Maleinimide verwendet werden.

4. Verfahren nach einem der Ansprüche 1 bis 3, dadurch gekennzeichnet, daß zusätzlich Haftvermittler, insbesondere Silane, verwendet werden.

5. Verfahren nach einem oder mehreren der Ansprüch 1 bis 4, dadurch gekennzeichnet, daß ein Additionsprodukt von Glycidylacrylat oder -methacrylat an das Polyadditionsprodukt aus Pyromellithsäure- oder Benzophenontetracarbonsäuredianhydrid und Diaminodiphenyläther verwendet wird.

6. Verfahren nach einem oder mehreren der Ansprüche 1 bis 4, dadurch gekennzeichnet, daß ein Additionsprodukt von Glycidylacrylat oder -methacrylat an das Polyadditionsprodukt aus Dihydroxydiphenylmethan-dicarbonsäure und Diphenylmethandiisocyanat verwendet wird.

7. Hochwärmebeständige Reliefstruktur, hergestellt nach einem oder mehreren der Ansprüche 1 bis 6.

8. Verwendung der Reliefstruktur nach Anspruch 7 als Resist mit intermediärer Schutzfunktion zur lithographischen Strukturierung von Oberflächen, insbesondere bei Trockenätzverfahren.

9. Verwendung der Reliefstruktur nach Anspruch 7 zur dauerhaften Beschichtung oder Rasterung von Oberflächen.

10. Verwendung der Reliefstruktur nach Anspruch 7 als Schutz- und Isolierstoff in der Elektrotechnik.

## Claims

1. A process for the production of highly heat-resistant relief structures having a polyimide, polyisoindoloquinazolindione, polyoxazindione, or polyquinazolindione basis, by the application of radiation-sensitive, soluble polymer precursors in the form of a layer or film to a substrate, irradiation of the layer or film through negative masks using actinic light or by the guiding of a light beam, electron beam or ion beam, removal of the non-irradiated parts of the layer or film, and possibly subsequent annealing, characterised in that as polymer precursors, there are used addition products of olefinically-unsaturated mono-epoxides with polyaddition products containing carboxyl groups, formed from aromatic and/or heterocyclic tetracarboxylic acid dianhydrides and diamino-compounds, which latter may contain at least one amido-group in the ortho position, or with poly-addition products containing carboxyl groups, formed from aromatic and/or heterocyclic dihydroxydicarboxylic acids, or the corresponding diaminodicarboxylic acids, and diisocyanates.

2. A process as claimed in Claim 1, characterised in that the polymer precursors are used together with light-sensitive or radiation-sensitive copolymerisable compounds.

3. A process as claimed in Claim 2, characterised in that N-substituted maleinimides are used as copolymerisable compounds.

4. A process as claimed in one of Claims 1 to 3, characterised in that bonding agents, in particular

silanes, are additionally used.

5. A process as claimed in one or more of Claims 1 to 4, characterised in that an addition product of glycidyl acrylate or methacrylate with the poly-addition product of pyromellitic acid dianhydride, or benzophenonetetracarboxylic acid dianhydride, and diaminodiphenylether is used.

6. A process as claimed in one or more of Claims 1 to 4, characterised in that an addition product of glycidyl acrylate or methacrylate with the poly-addition product of dihydroxydiphenylmethánedicarboxy lic acid and diphenylmethane diisocyanate is used.

7. A highly heat-resistant relief structure produced in accordance with one or more of Claims 1 to 6.

8. The use of the relief structure as claimed in Claim 7 as a resist having an intermediate protective function in the lithographic structuring of surfaces, in particular in dry etching processes.

9. The use of the relief structure as claimed in Claim 7 for the permanent coating or embossing of surfaces.

10. The use of the relief structure as claimed in Claim 7 as a protective and insulating material in electrical technology.

**Revendications**

1. Procédé de fabrication de structures en relief stables à haute température à base de polyimides, de polyisoindoloquinazolinediones, de polyoxazinediones et de polyquinazolinediones, en appliquant sur un substrat des précurseurs de polymères solubles, sensibles à un rayonnement, sous la forme d'une couche ou d'une feuille, en exposant la couche ou feuille à de la lumière actinique à travers des modèles négatifs ou en envoyant un faisceau lumineux, d'électrons ou d'ions, en éliminant les parties de couche ou de feuille non exposées et éventuellement en soumettant à un recuit ultérieur, caractérisé en ce qu'il consiste à utiliser comme précurseurs de polymères des produits d'addition de monoépoxyde à insaturation oléfinique sur des produits de polyaddition, contenant des groupes carboxyliques, de dianhydrides d'acides tétracarboxyliques aromatiques et/ou hétérocycliques et de composés diamino, ces derniers pouvant contenir au moins un groupe amido en position ortho, ou sur des produits de polyaddition, contenant des groupes carboxyliques, d'acides dihydroxydicarboxyliques aromatiques et/ou hétérocycliques ou d'acides diaminodicarboxyliques correspondants et de diisocyanates.

2. Procédé suivant la revendication 1, caractérisé en ce qu'il consiste à utiliser les précurseurs de polymères en même temps que des composés sensibles à la lumière ou au rayonnement aptes à copolymériser.

3. Procédé selon la revendication 2, caractérisé en ce qu'il consiste à utiliser comme composé apte à copolymériser des maléinimides substitués sur l'azote.

4. Procédé selon l'une des revendications 1 à 3, caractérisé en ce qu'il consiste à utiliser en outre des agents de pontage, notamment des silanes.

5. Procédé selon l'une ou plusieurs des revendications 1 à 4, caractérisé en ce qu'il consiste à utiliser un produit d'addition d'acrylate de glycidyle ou de méthacrylate de glycidyle sur le produit de polyaddition de dianhydride d'acide pyromellitique ou de dianhydride d'acide benzophénonetétracarboxylique et d'éther diaminodiphénylique.

6. Procédé selon l'une ou plusieurs des revendications 1 à 4, caractérisé en ce qu'il consiste à utiliser un produit d'addition d'acrylate de glycidyle ou de méthacrylate de glycidyle sur le produit de polyaddition d'acide dihydroxydiphénylméthanedicarboxylique et de diisocyanate de diphénylméthane.

7. Structure en relief stable à haute température fabriquée selon l'une ou plusieurs des revendications 1 à 6.

8. Utilisation de la structure en relief suivant la revendication 7 comme composition photorésistante ayant une fonction intermédiaire de protection pour la structuration par voie lithographique de surface, notamment dans un procédé d'attaque par voie sèche.

9. Utilisation de la structure en relief selon la revendication 7 pour le revêtement permanent de surfaces ou le quadrillage permanent de surfaces.

10. Utilisation de la structure en relief suivant la revendication 7, comme matière de protection et isolante en électrotechnique.